Europäisches Patentamt

European Patent Office

Office européen des brevets

⑱

(11) Publication number: **0 148 820**
**B1**

(12) **EUROPEAN PATENT SPECIFICATION**

(45) Date of publication of patent specification: **12.10.88**

(21) Application number: **83902413.0**

(22) Date of filing: **11.07.83**

(86) International application number:
**PCT/US83/01069**

(87) International publication number:
**WO 85/00467 31.01.85 Gazette 85/03**

(51) Int. Cl.⁴: **H 01 L 23/48, H 05 K 7/10**

(54) **ELECTRONIC CIRCUIT CHIP CONNECTION ASSEMBLY AND METHOD.**

(43) Date of publication of application:
**24.07.85 Bulletin 85/30**

(45) Publication of the grant of the patent:
**12.10.88 Bulletin 88/41**

(84) Designated Contracting States:
**AT BE CH DE FR GB LI LU NL SE**

(56) References cited:
**EP-A-0 083 265**
**FR-A-2 288 394**
**US-A-3 335 327**
**US-A-4 164 003**
**US-E- 31 114**

(73) Proprietor: **SILICON CONNECTION, INC.**
**P.O. Box 6519 1250 S. Wilson Way**
**Stockton, CA 95205 (US)**

(72) Inventor: **SCHROEDER, Jon, Murray**
**4327 Estate Drive**
**Stockton, CA 95209 (US)**

(74) Representative: **Purvis, William Michael**
**Cameron et al**
**D. Young & Co. 10 Staple Inn**
**London WC1V 7RD (GB)**

Courier Press, Leamington Spa, England.

## Description

The invention relates generally to the technical field of electronic circuit packaging and more particularly to interconnecting an electronic circuit chip and a printed circuit board.

Both monolithic and hybrid integrated circuit chips, as are well known in the art, require coupling to external circuits for their proper operation. Such coupling is necessary for supplying power for such circuits to operate, for applying input signals to such circuits, and for transmitting output signals from such circuits to other devices. Consequently, such integrated circuit chips generally include a number of small, rectangularly shaped, conductive areas, frequently referred to in the trade as "pads". Such pads, generally arranged about the periphery of one of the chip's planar surfaces, are used for coupling the chip to external circuits. As presently, most commonly used, the various types of mechanical enclosures in which such integrated circuit chips are packaged include a plurality of conductors which interconnect such pads to corresponding electrical conductors on a printed circuit board and which are frequently referred to in the trade as "traces".

Presently, the method employed most widely to establish the interconnections between an integrated circuit chip's pads and a printed circuit board's traces includes bonding a plurality of individual electrical wires between the pads and other conductors included in the package which mechanically encloses the chip. Most commonly, each such individual wire is attached to the electronic circuit chip's pads manually either by thermo-compression bonding or by ultrasonic bonding. The use of such manual methods for establishing such interconnections frequently causes that operation to be a significant cost, and perhaps even the dominant cost, in the high volume manufacture of monolithic integrated circuits.

Recognizing that significant economies might be achieved if it were possible simultaneously to form all the interconnections to an electronic circuit chip's pads simultaneously in a single operation, methods and machines have been developed for forming such interconnections which employ a plurality of conductors, specially preformed at a plurality of successive sites along the length of a metallic tape. For various reasons, such tape bonding methods have failed to gain wide acceptance within the electronics industry. Consequently, manual bonding employing a plurality of individual wires presently remains the most widely used method.

In addition to requiring relatively expensive, manual methods for interconnecting the pads of an electronic circuit chip with conductors included in its mechanical package, generally that package's shape and the structures used to interconnect that package to the printed circuit board's traces occupy a significant amount of space on the board. Further, the most widely used integrated circuit chip package also exhibits significant differences among the electrical characteristics of its various conductors which can upset the timing of signals critical to the proper operation of an electronic circuit chip.

Responding to these various deficiencies in present integrated circuit packaging technology, a new assembly for and method of connecting an electronic circuit chip to a printed circuit board was invented. This new assembly and method, which is described in a Patent Co-operation Treaty patent application entitled "Electronic Circuit Chip Connection Assembly and Method" filed November 9, 1982 with the United States Patent and Trademark Office as the Receiving Office and assigned International Application Number PCT/US82/01584/(≡EP-A-63584), was invented by the same inventor and is assigned to the same assignee as the present invention. In that prior invention, the assembly includes a pressure connection frame having an aperture for receiving an electronic circuit chip and making electrical contact thereto, and also for making electrical contact to electrically conductive traces on a printed circuit board. The assembly further includes a connection pressure pad secured to the pressure connection frame about the aperture into which the electronic circuit chip is received. The pressure connection frame together with the electronic circuit chip received therein and with the connection pressure pad is enclosed by a cover such that the electronic circuit chip is immediately adjacent to the cover. Securing the cover to the printed circuit board completes formation of the assembly thereby establishing the connections between the electronic circuit chip and the printed circuit board's traces and urging the chip into intimate contact with the cover.

A particular advantage of this new electronic circuit chip package is that it can efficiently dissipate heat generated by the chip's operation to surrounding atmosphere if the assembly's cover is fabricated from a high thermal conductivity material such as a metal. Further, employing such a metal cover in this assembly facilitates forming an electrical connection with the chip's substrate, if required, by merely including an electrical contact to the cover among the printed circuit board's traces. While such efficient heat dissipation is necessary to the operation of certain types of integrated circuits such as those employing emitter-coupled logic circuits, high performance linear circuits, and high performance random access memory, not all types of integrated circuits require such efficient heat dissipation. For example, integrated circuit chips employing complementary MOS circuits ("CMOS") generally do not generate a great deal of heat nor do they frequently require an electrical connection to their substrate.

According to one aspect of the invention there is provided a chip connecting assembly for coupling an electronic circuit chip to a printed circuit board characterised by:
a connection pressure plate fabricated of a resilient material to receive the electronic circuit chip on one face thereof;

electronic circuit connection means electrically to connect the electronic circuit chip received on said one face of the connection pressure plate to the printed circuit board; and

a cover to be secured to the printed circuit board and to enclose the connection pressure plate, the electronic circuit connection means and the electronic circuit chip with said one face of the connection pressure plate facing away from the cover; the assembly being so arranged that, when the cover is secured to the printed circuit board, the connection pressure plate exerts a pressure urging the electronic circuit connection means into intimate contact with both the electronic circuit chip and the printed circuit board thereby electrically to connect the electronic circuit chip to the printed circuit board.

According to another aspect of the invention there is provided a method of coupling an electronic circuit chip to a printed circuit board characterised by the operations of:

mounting the electronic circuit chip on one face of a connection pressure plate fabricated of resilient material;

disposing electronic circuit connection means about the electronic circuit chip received on said one face of the connection pressure plate.

locating the electronic circuit connection means, the connection pressure plate, and the electronic circuit chip within a cover with said one face of the connection pressure plate facing away from the cover; and

securing the cover to the printed circuit board to cause the connection pressure plate to exert a pressure urging the electronic circuit connection means into intimate contact with both the electronic circuit chip and the printed circuit board thereby electrically to connect the electronic circuit chip to the printed circuit board.

Such an assembly for and method of connecting an electronic circuit chip to a printed circuit board can be simple and inexpensive and need only occupy a small area on the printed circuit board.

The assembly can have closely matched characteristics among its numerous conductors and can be suitable for use with chips requiring a large number of individual connections.

After being received on said face of the connection pressure plate, the chip is contacted by the electronic circuit connection means which includes a plurality of conductors for coupling between pads on the electronic circuit chip and traces on the printed circuit board. The connection pressure plate together with the electronic circuit chip and the electronic circuit connection means is located within the cover and the electronic circuit chip, when secured within the cover with the assembled connection pressure plate and electronic circuit connection means is located immediately adjacent to the printed circuit board so that the electronic circuits which it contains are coupled to the traces of the printed circuit board.

Preferably the connection pressure plate is fabricated from a resilient elastomer material and includes a pair of adjacent, concentric, raised ribs which encircle its periphery and project outward from the face thereof opposite to said face which receives the electronic circuit chip. Consequently, when the connection pressure plate is located within the cover, both of these ribs contact its interior surface and are compressed when the cover is secured to the printed circuit board. When so assembled, the innermost of the pair of raised ribs applies a force to the electronic circuit connection means urging it into intimate contact with the printed circuit board traces. Similarly compressed, the outermost of the raised ribs seals between the surfaces of the cover and the printed circuit board hermetically enclosing the electronic circuit chip within the assembly. Yet a third rib, projecting from the same surface of the connection pressure plate as the first two, encloses the plate's centermost region to apply a force to the electronic circuit chip urging it into intimate contact with the electronic circuit connection means.

Because the connection pressure plate's elastomeric material is located between the electronic circuit chip and the assembly's cover, it is difficult to establish an electrical connection between the chip's substrate and the printed circuit board's traces simply by employing a metallic cover and connecting one of the board's traces thereto. In those instances in which proper operation of an electronic circuit chip requires forming a connection to the chip's substrate, it is desirable to employ a substrate connection means which is applied to the connection pressure plate's surface before the chip is received thereon. Such substrate connection means extends outward beyond the periphery of a received chip to contact the electronic circuit connection means and hence be coupled via such means to one of the printed circuit board's traces. In this embodiment, yet a fourth raised rib projects from the connection pressure plate's surface between the innermost of the pair of ribs at its periphery and the third rib about its centermost region to apply a force urging the substrate connection means into intimate contact with the electronic circuit connection means.

In addition to establishing a barrier to electrical conductivity, the connection pressure plate's elastomeric material also impedes the flow of heat out of the electronic circuit chip into the atmosphere surrounding the assembly. While in many instances this thermal barrier would prevent connection of an electronic circuit chip to a printed circuit board using the assembly of the invention, for electronic circuit chips employing low power circuits such as CMOS no such difficulty exists.

The invention is diagrammatically illustrated by way of example in the accompanying drawings, in which:-

Figure 1 is a partially sectioned, exploded, perspective view of a chip connecting assembly in accordance with the present invention including a cover, an electronic circuit chip, a connection pressure plate, an electronic circuit connection means, and a printed circuit board;

Figure 2 is a cross-sectional view of the chip connecting assembly taken along line 2-2 of Figure 1:

Figure 3B to 3D are cross-sectional views showing the connection pressure plate receiving the electronic circuit chip, the mounting of the electronic circuit connection means on the chip and plate, and then the location of the plate, chip, and connection means within the cover;

Figure 4 is a cross-sectional view of a metallic conductor taken along line 4-4 of Figure 2;

Figure 5 is a plan view of the connection pressure plate, chip, and electronic circuit connection means of Figure 3 showing alignment of the chip and connection means with the plate;

Figure 6 is a cross-sectional view of the assembled cover, connection pressure plate, electronic circuit chip, electronic circuit connection means, and printed circuit board taken along line 6-6 of Figure 2 showing the coupling of the chip's pad to a printed circuit board's trace: and

Figure 7A to 7C are cross-sectional views showing the application of a substrate connection means to the connection pressure plate prior to its receiving the electronic circuit chip, the receiving of such chip, and then mounting of the electronic circuit connection means on the chip and plate.

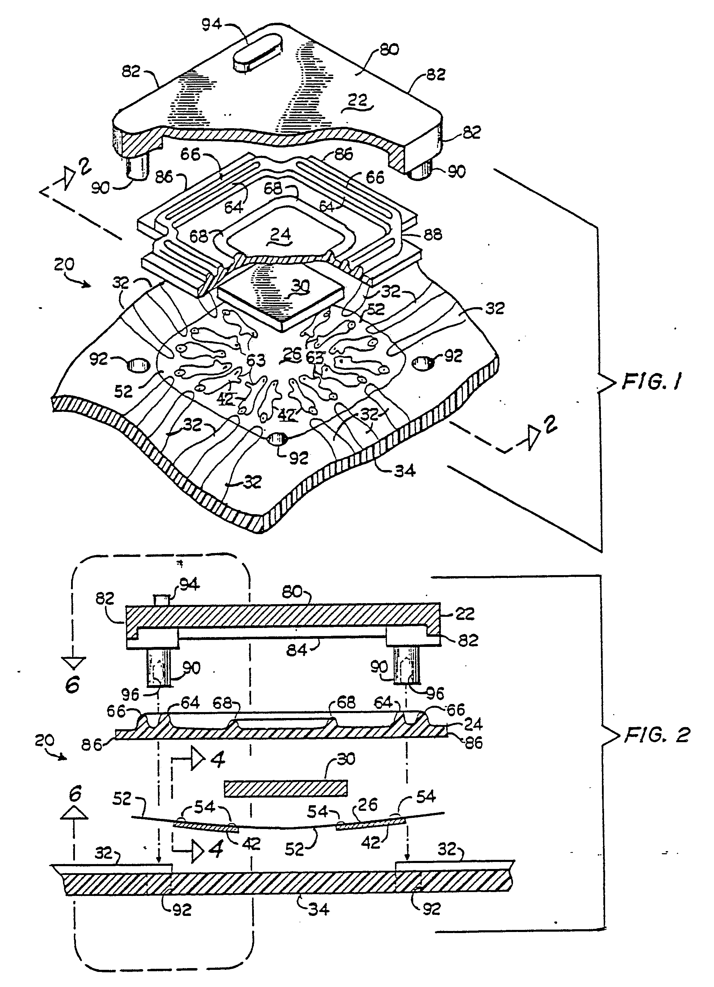

Figures 1 and 2 show an assembly 20 comprising a cover 22, a connection pressure plate 24, and an electronic circuit connection means 26 for coupling a rectangularly shaped electronic circuit chip 30 to traces 32 of a printed circuit board 34.

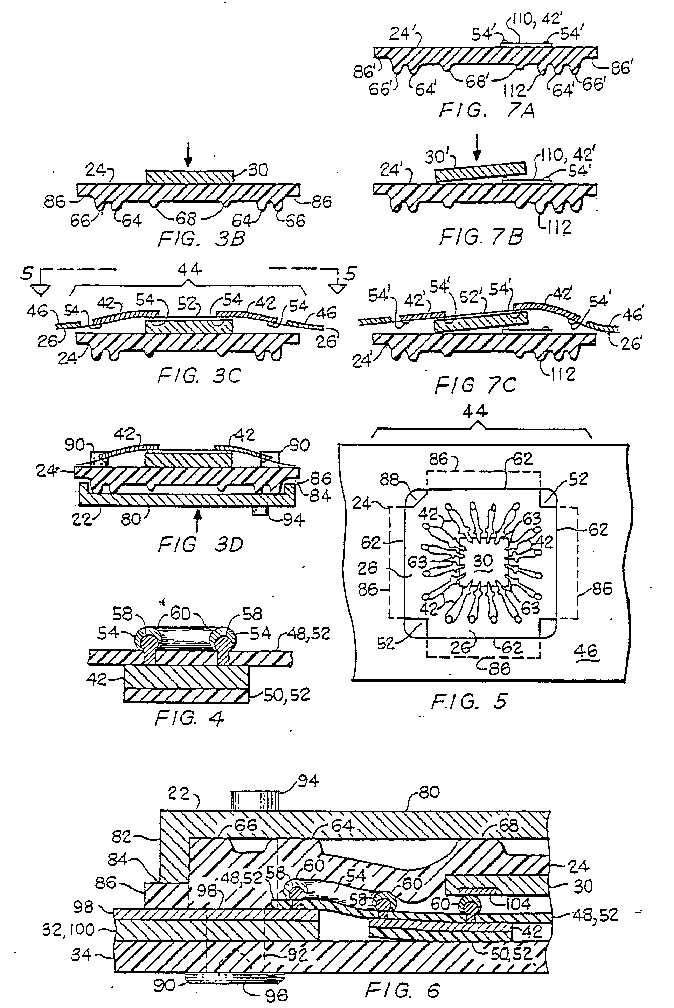

As shown in Figures 3C and 5, the electronic circuit connection means 26 includes a plurality of metallic electrical conductors 42 preformed repetitively at a plurality of individual sites 44 along a length of aluminum tape 46 approximately 19.0 μm thick. As shown in Figures 4 and 6, the conductors 42 are formed in the metallic tape 46 by first coating both an upper surface 48 and a lower surface 50 with an approximately 25.0 μm thick film 52 comprising a photoresist material in which is suspended a slurry of glass beads having a nominal diameter of approximately 10 μm. The film 52 on the lower surface 50 is then exposed successively at each site 44 with a pattern for the metallic conductors 42. Alternatively, the upper surface 48 is exposed with a pattern for forming a plated electrical contact 54 respectively at each terminal end of the conductors 42. After the film 52 on the surfaces 48 and 50 has been exposed with the respective patterns by ultraviolet light, it is then developed to provide apertures through which the electrical contacts 54 are plated onto the upper surface 48 of the metallic tape 46 and through which the aluminum material of the tape 46 is subsequently removed by etching to establish the individual metallic conductors 42.

Referring now to Figure 4, the electrical contact 54 at that end of each metallic conductor 42 which respectively connects to the trace 32 of the printed circuit board 34 is formed in the shape of an elongate oval having a width of approximately 100 μm and a length of between 250 and 500 μm. The contact 54 is formed by first floating the upper surface 48 of the metallic tape 46 on a liquid solution from which is plated a core 58 of silver material. This silver core 58 of the contact 54 is plated up through the thickness of the film 52 on the upper surface 48 to a thickness of approximately 70 μm. Then, the upper surface 48 of the tape 46 is floated on a liquid solution from which is plated a thin gold outer surface 60 of the contact 54. In addition to forming the elongate oval electrical contact 54 at the ends of the metallic conductors 42 which connect to the traces 32 of the printed circuit board 34, similar circular electrical contacts 54 having the same thickness and a diameter of approximately 35 m are also formed respectively at the opposite end of each metallic conductor 42 for contacting the electronic circuit chip 30.

After plating has been completed, the lower surface 50 of the metallic tape 46 is then floated on a liquid solution which etches away the aluminum material of the tape 46 to form the metallic conductors 42. The pattern used to form the conductors 42 is shaped such that the elongate oval electrical contact 54 for contacting the traces 32 of the printed circuit board 34 projects outward beyond the etched terminal end of the conductor 42 as is shown in Figure 6. Contrarily, that same pattern leaves the metallic material of the tape 46 totally surrounding the base of the circular electrical contact 54 for contacting the electronic circuit chip 30. Because the film 52 coated onto the upper surface 48 of the tape 46 almost completely covers its surface except in those locations at which the contacts 54 are plated through that film 52, the metallic conductors 42, formed by etching successive sites 44 along the length of the tape 46, are supported in that location by the film 52 of the upper surface 48 which bridges from the conductors 42 to an outer edge 62 of each site 44. Since the film 52 is comparatively soft and flexible, the accuracy and stability of the location of those electrical contacts 54 which contact the electronic circuit chip 30 is increased by forming the adjoining edges of the terminal ends of adjacent metallic conductors 42 with bulges 63 located outward from and just beyond the edges of the electronic circuit chip 30. Thus adjacent metallic conductors 42 project outward toward each other at those locations to become juxtaposed thereby maintaining the conductors 42 in a spaced relationship for proper mating with the electronic circuit chip 30.

The connection pressure plate 24, which is cast from a resilient elastomer material having a hardness between 20 and 40 durometers such as Dow Corning Sylgard 184, is formed with an electrical contact rib 64 immediately adjacent to a hermetic seal rib 66. The pair of raised ribs 64 and 66 both encircle the connection pressure plate 24 about its periphery to project outward from the surface thereof opposite to that which engages the electronic circuit chip 30. A third, central rib 68 also projects from that same surface of the connection pressure plate 24 to enclose its centermost region.

Figures 3B to 3D show the steps by which the electronic circuit chip 30 is assembled together with the connection pressure plate 24, the electronic circuit connection means 26, and the cover 22. As shown in Figure 3B, the electronic circuit chip 30 is merely placed onto that surface of the connection pressure plate 24 opposite to that from which the ribs 64, 66 and 68 project. The electronic circuit chip 30 must be properly oriented with respect to and accurately located on the surface of the connection pressure plate 24 which receives it to ensure proper alignment for all subsequent assembly operations and hence the operability of the chip 30 after assembly has been completed. Since the elastomer material identified hereinabove, when cured, has a tacky surface, no additional operation or surface preparation is required to ensure that the electronic circuit chip 30 will remain in that location during moderate handling in subsequent assembly operations. After the electronic circuit chip 30 has been thus located on the connection pressure plate 24, the electronic circuit connection means 26 is aligned to the chip 30 as shown in Figure 5 and then it is gently urged onto the elastomer by an acrylic pressure foot (not shown). During the operation, shown in Figure 3C, by which the electronic circuit connection means 26 is transferred from the site 44 of the tape 46 to the surfaces of the electronic circuit chip 30 and the connection pressure plate 24, the metallic conductors 42 maintain their positions in relationship to the chip 30 and the film 52 of the connection means 26 tears free from the tape 46 to adhere, together with the conductors 42, to the tacky surface of the plate 24. After the electronic circuit connection means 26 has been located over the electronic circuit chip 30 and applied to the connection pressure plate 24, the subassembly thus formed is placed into the cover 22 with the ribs 64, 66, and 68 immediately adjacent to its interior surface.

The rectangularly shaped cover 22 of the assembly 20 is shaped to receive the connection pressure plate 24 carrying the electronic circuit chip 30 and the bonded electronic circuit connection means 26 by being formed with an outer wall 80 surrounded by four side walls 82. The interior surface of the cover 22, formed by the walls 80 and 82, is shaped to receive and to mate with the hermetic seal rib 66 of the connection pressure plate 24. Similarly, the side walls 82 are formed with reliefs 84 for receiving projecting tabs 86 of the plate 24. The interior surfaces of the walls 82 at one corner of the cover 22 are shaped differently from the three remaining corners to receive a diagonally shaped key 88 formed by the ribs 64 and 66 of the connection pressure plate 24. This keying of the connection pressure plate 24 to the cover 22 maintains the orientation of the electronic circuit chip 30 within the cover 22.

The cover 22 also includes four projecting pins 90, one such pin 90 being respectively located about each corner thereof. The printed circuit board 34 is fabricated with mating holes 92 for receiving the pins 90. The cover 22 is further formed with a tab 94 projecting from the outer surface of its outer wall 80 for easily establishing the orientation of the electronic circuit chip 30 within the assembly 20.

Thus, once the cover 22 carrying the connection pressure plate 24, the electronic circuit chip 30, and the electronic circuit connection means 26 is inverted and properly oriented with respect to the traces 32 of the printed circuit board 34 by reference to the tab 94, the assembly 20 together with the electronic circuit chip 30 may be properly positioned on the printed circuit board 34 by inserting the pins 90 into the holes 92. The pins 90 are formed with hollow centres 96 to facilitate securing the cover 22 to the printed circuit board 34 by swaging the ends of the pins 90 which project through the printed circuit board 34 as is shown in Figure 6.

With the cover 22 of the assembly 20 thus secured to the printed circuit board 34, the elongate oval electrical contact 54, located at that end of each metallic conductor 42 which respectively connects with the traces 32 and as surrounded by the film 52 applied to the upper surface 48 of the metallic tape 46, is urged into contact with a gold surface 98 plated onto the copper material 100 of the trace 32. The force urging such contact 54 into intimate contact with the gold plated surface 98 of the trace 32, which is in the range of 69 to 138 newtons per square centimeter (100 to 200 pounds per square inch), is supplied by the compression of the electrical contact rib 64 against the interior surface of the outer wall 80 of the cover 22. This contact between the elongate oval contact 54 and the gold plated surface 98 of the trace 32 establishes an electrical connection between the trace 32 and the metallic conductor 42. Similarly, the compression of the hermetic seal rib 66 against the walls 80 and 82 of the cover 22 establishes a force (of the same magnitude as that normally used with "O" ring seals) which urges the connection pressure plate 24 toward the printed circuit board 34 and the traces 32 located thereon hermetically to seal the electronic circuit chip 30 within the assembly 20 and the printed circuit board 34.

As also shown in Figure 6, securing the cover 22 of the assembly 20 to the printed circuit board 34 similarly compresses the central rib 68 against the inner surface of the outer wall 80. The central rib 68, as originally cast, does not project as far outward from the surface of the connection pressure plate 24 as do the ribs 64 and 66. This compensates for the greater thickness of the electronic circuit chip 30. The force established by compressing the central rib 68 against the surface of the cover 22 is applied to the electrical contacts 54 located at the ends of the metallic conductors 42 which contact the electronic circuit chip 30. This force urges each such contact 54 into intimate contact with a contact pad 104 located on the surface of the chip 30 with a force in the range of 6,900 to 13,800 newtons per square centimeter (10,000 to 20,000 pounds per square inch) thereby establishing an electrical connection between such pad 104 and the metallic conductor 42. The formation of an electrical connection between any other portion of the metallic conductor 42 and the chip 30 other than at the electrical contact 54 is prevented by the presence of the glass beads compounded into the material of the film 52. The glass beads in the film 52 provide a mechanically strong electrically insulating material which selectively coats the surface of the metallic conductors 42 to prevent the formation of unintended electrical connections between the metallic conductors 42 and the electronic circuit chip 30.

For those types of electronic circuit chip 30 which require an electrical connection to their substrate for proper operation the assembly 20, in an alternative embodiment depicted in Figures 7A to 7C, incorporates such a substrate connection means 110. Those elements common to the assembly 20 carry the same reference numeral distinguished by a single prime designation. As shown in Figure 7A, the substrate connection means 110 includes a metallic conductor 42' having electrical contacts 54' and which is applied to the surface of the connection pressure plate 24' before it receives the electronic circuit chip 30'. The substrate connection means 110 may be fabricated in the same manner as that described hereinabove for the electronic circuit connection means 26. Thus the electrical contact 54' at one end of the metallic conductor 42' adapts the substrate connection means 110 to contact the surface of the electronic circuit chip 30' opposite to that to be contacted by the electronic circuit connection means 26' while the electrical contact 54' at its other end contacts the electronic circuit connection means 26' itself.

Further, in this alternative embodiment the connection pressure plate 24' includes yet a fourth, substrate contact rib 112 projecting outward from the same surface of the connection pressure plate 24' as do the ribs 64', 66', and 68'. The substrate contact rib 112 is located between the electrical contact rib 64' and the central rib 68' for urging the end of its metallic conductor 42' extending outward beyond the periphery of the received electronic circuit chip 30' into intimate contact with one of the metallic conductors 42' of the electronic circuit connection means 26'. After the connection pressure plate 24' has been inserted into the cover 22' and the cover 22' has been secured to the printed circuit board 34', the substrate contact rib 112 urges the substrate connection means 110 and the electronic circuit connection means 26' into intimate contact thereby electrically coupling the substrate of the electronic circuit chip 30' to the traces 32' of the printed circuit board 34'.

Figure 7B, which corresponds to Figure 3B, shows the electronic circuit chip 30' being received onto the connection pressure plate 24' to contact the substrate connection means 110. Similarly, Figure 7C, which corresponds to Figure 3C, shows application of the electronic circuit connection means 26' to the surfaces of the electronic circuit chip 30', the substrate connection means 110, and the connection pressure plate 24'. All other aspects of this alternative embodiment assembly 20' not explicitly described are identical to those described herein for the assembly 20.

Because of the small size of the oval electrical contact 54 at the end of the metallic conductor 42 which connects to the trace 32 of the printed circuit board 34, adjacent contacts 54 may be spaced as close together as 0.4 mm with only 0.2 mm gaps separating adjacent metallic conductors 42. Such close spacing of adjacent contacts 54 permits coupling an electronic circuit chip 30 requiring 100 individual electrical conductors 42 to a printed circuit board 34 within a square area occupied by the cover 22 having a length of 19.0 mm along each of its four sides. This ability to place the electrical contacts 54 close together also produces shorter and more uniform lengths for the leads interconnecting the electronic circuit chip 30 to the printed circuit board 34 which results in more closely matched characteristics among the numerous electrical conductors 42.

While a preferred embodiment employs a resilient elastomer material to fabricate the pressure connection plate 24, the use of such material is required by mechanical variations in the thickness of the various parts of the assembly 20 and in the thickness of the electronic circuit chip 30. If the variations in the thickness of these various components were more precisely controlled, it is possible that a less resilient material could be used in fabricating the connection pressure plate 24.

The preferred method of initially establishing the proper orientation of the electronic circuit chip 30 to the connection pressure plate 24, when such chip 30 is a monolithic integrated circuit, is to bond an entire wafer (not shown) of such chips to a sheet of adhesive material (not shown) before such wafer is cut into chips 30. After such dicing operation has been completed thus forming the chips 30, they remain attached to the sheet of adhesive thereby preserving their orientation with respect to the wafer until such time as they are removed from the sheet of adhesive to be received on the connection pressure plate 24. The use of such sheet adhesive in combination with the structure of the plate 24 and the cover 22 with their respective inclusion of an orientation preserving structure such as the tab 94 thereby adapts the assembly 20 to semi-automatic or even perhaps fully automatic packaging of such electronic chips 30.

**Claims**

1. A chip connecting assembly (20) for coupling an electronic circuit chip (30) to a printed circuit board (34) characterised by:

a connection pressure plate (24) fabricated of a resilient material to receive the electronic circuit chip (30) on one face thereof;

electronic circuit connection means (26) electrically to connect the electronic circuit chip (30) received on said one face of the connection pressure plate (24) to the printed circuit board (34); and a cover (22) to be secured to the printed circuit board (34) and to enclose the connection pressure plate (24), the electronic circuit connection means (26) and the electronic circuit chip (30) with said one face of the connection pressure plate (24) facing away from the cover (22); the assembly (20) being so arranged that, when the cover (22) is secured to the printed circuit board (34), the connection pressure plate (24) exerts a pressure urging the electronic circuit connection means (26) into intimate contact with both the electronic circuit chip (30) and the printed circuit board (34) thereby electrically to connect the electronic circuit chip (30) to the printed circuit board (34).

2. A chip connecting assembly according to claim 1, including substrate connection means (110) on said one face of the connection pressure plate (24) to couple a substrate of the electronic circuit chip (30) to the printed circuit board (34) when the assembly (20) couples the electronic circuit chip (30) to the printed circuit board (34).

3. A chip connecting assembly according to claim 1, wherein the connection pressure plate (24) is fabricated from a resilient elastomer having a hardness between 20 and 40 durometers.

4. A chip connecting assembly according to claim 2, wherein the connection pressure plate (24) is fabricated from a resilient elastomer having a hardness between 20 and 40 durometer.

5. A chip connecting assembly according to any one of claims 1 to 4, including sealing means (66) hermetically to seal the electronic circuit chip (30) within the chip connecting assembly (20).

6. A chip connecting assembly according to claim 5, wherein the sealing means includes a sealing rib (66) projecting from a surface of the connection pressure plate (24) to compress the connection pressure plate (24) between an interior surface of the cover (22) and the printed circuit board (34) when the chip connecting assembly (20) couples the electronic circuit chip (30) to the printed circuit board (34), which compression causes the connection pressure plate (24) to mate with and to form a seal with such surfaces.

7. A chip connecting assembly according to any one of claims 1 to 4, wherein the electronic circuit connection means includes a plurality of individual metallic conductors (42) each having a chip contacting terminal (54) disposed about the electronic circuit chip (30) for contacting the electronic circuit chip (30), and also having a trace contacting terminal (54) disposed about a trace (32) of the printed circuit board for contacting such trace (32) when the chip connecting assembly (20) couples the electronic circuit chip (30) to the Printed circuit board (34).

8. A chip connecting assembly according to claim 7, wherein the metallic conductors (42) of the electronic circuit connection means (26) are bonded to a sheet of insulating film (52) material, and wherein the adjoining edges of immediately adjacent metallic conductors (42) about the chip contacting terminals (54) thereof project outward toward each other to become juxtaposed, whereby the chip contacting terminals (54) of the metallic conductors (42) are maintained in a spaced relationship so as properly to mate with contact pads (104) of the electronic circuit chip (30).

9. A chip connecting assembly according to claim 7, wherein the metallic conductors (42) are selectively coated with a mechanically strong, electrically insulating material for preventing the formation of unintended electrical contacts between the metallic conductors (42) and the electronic circuit chip (30) when the chip connecting assembly (20) connects the electronic circuit chip (30) to the printed circuit board (34).

10. A chip connecting assembly according to claim 7, wherein the metallic conductors (42) of the electronic circuit connection means are immediately adjacent to the surface of the printed circuit board (34) contacted by the trace contacting terminals (54) of the metallic conductors (42) when the chip connecting assembly (20) couples the electronic circuit chip (30) to the printed circuit board (34).

11. A chip connecting assembly according to claim 7, wherein the connection pressure plate (24) is formed with a projecting surface (64) located about the trace contacting terminals (54) of the metallic conductors (42) to urge such trace contacting terminals (54) into intimate contact with the traces (32) of the printed circuit board (34) when the chip connecting assembly (20) couples the electronic circuit chip (30) to the printed circuit board (34).

12. A chip connecting assembly according to claim 7, wherein the connection pressure plate (24) is formed with a projecting surface (68) located about the chip contacting terminals (54) of the metallic conductors (42) to urge such chip contacting terminals (54) into intimate contact with the electronic circuit chip (30) when the chip connecting assembly (20) connects the electronic circuit chip (30) to the printed circuit board (34).

13. A method of coupling an electronic circuit chip (30) to a printed circuit board (34) characterised by the operations of:

mounting the electronic circuit chip (30) on one face of a connection pressure plate (24) fabricated of resilient material;

disposing electronic circuit connection means (26) about the electronic circuit chip (30) received on said one face of the connection pressure plate (24);

locating the electronic circuit connection means (26), the connection pressure plate (24), and the electronic circuit chip (30) within a cover (22) with said one face of the connection pressure plate (24) facing away from the cover (22); and

securing the cover (22) to the printed circuit board (34) to cause the connection pressure plate (24) to exert a pressure urging the electronic circuit connection means (26) into intimate contact with both the electronic circuit chip (30) and the printed circuit board (34) thereby electrically to connect the electronic circuit chip (30) to the printed circuit board (34).

14. A method according to claim 13, including the operating of mounting a substrate connection means (110) to said one face of the connection pressure plate (24) prior to mounting the electronic circuit chip (30) thereon.

15. A method according to claim 13 or claim 14, wherein the connection pressure plate (24) is fabricated from a resilient elastomer having a hardness between 20 and 40 durometers.

16. A method according to claim 13 or claim 14 including the operation of hermetically sealing the electronic circuit chip within an assembly comprising the connection pressure plate (24), the electronic circuit connection means (26), the cover (22), and the printed circuit board (34) when the cover (22) is secured to the printed circuit board (34).

17. A method according to claim 13 or claim 14, including the operation of forming electrical conductors (42) included in the electronic circuit connection means (26) in a web of metallic material, each such metallic conductor (42) being formed with a chip contacting terminal (54) to be disposed about the electronic circuit chip (30) so as to contact the electronic circuit chip (30), and also being formed with a trace contacting terminal (54) to be disposed about a trace (32) of the printed circuit board (34) so as to contact such trace (32) when the cover (22) is secured to the printed circuit board (34).

18. A method according to claim 17, wherein the metallic conductors (42) of the electronic circuit connection means (26) are bonded to a sheet of insulating film material (52), and wherein the adjoining edges of immediately adjacent metallic conductors (42) about the chip contacting terminals (54) thereof are formed to project outward toward each other to become juxtaposed, whereby the chip contacting terminals (54) of the metallic conductors are maintained in a spaced relationship so as properly to mate with contact pads (104) of the electronic circuit chip (30).

19. A method according to claim 17, including the operation of selectively forming a mechanically strong, electrically insulating coating on the metallic conductors (42) to prevent the formation of unintended electrical contacts between the metallic conductors (42) and the electronic circuit chip (30) upon securing of the cover (22) to the printed circuit board (34).

**Patentansprüche**

1. Chipverbindungsanordnung (20) zum Ankop-

peln eines elektronischen Schaltungschips (30) an eine gedruckte Schaltplatte (34), gekennzeichnet durch:

eine Verbindungsdruckplatte (24), die aus einem elastischen Material hergestellt ist, um den elektronischen Schaltungschip (30) auf ihrer einen Fläche aufzunehmen;

elektronische Schaltungsverbindungsmittel (26), um elektrisch den elektronischen Schaltungschip (30), der auf der einen Fläche der Verbindungsdruckplatte (24) aufgenommen ist, mit der gedruckten Schaltplatte (34) zu verbinden; und eine Abdeckung (22), die an der gedruckten Schaltplatte (34) angebracht werden soll, um die Verbindungsdruckplatte (24) einzuschließen, wobei das Verbindungsmittel (26) für die elektronische Schaltung und der elektronische Schaltungschip (30) mit der einen Fläche der Verbindungsdruckplatte (24) von der Abdeckung (22) fortgerichtet sind; die Anordnung (20) so angeordnet ist, daß wenn die Abdeckung (22) an der gedruckten Schaltplatte (34) befestigt ist, die Verbindungsdruckplatte (24) einen Druck ausübt, welcher das elektronische Schaltungsverbindungsmittel (26) in innigen Kontakt sowohl mit dem elektronischen Schaltungschip (30) als auch mit der gedruckten Schaltplatte (34) drückt, um dadurch elektrisch den elektronischen Schaltungschip (30) mit der gedruckten Schaltplatte (34) zu verbinden.

2. Chipverbindungsanordnung nach Anspruch 1, mit Substratverbindungsmitteln (110) auf der einen Fläche der Verbindungsdruckplatte (24), um ein Substrat des elektronischen Schaltungschips (30) an die gedruckte Schaltplatte (34) anzukoppeln, wenn die Anordnung (20) den elektronischen Schaltungschip (30) an die gedruckte Schaltplatte (34) ankoppelt.

3. Chipverbindungsanordnung nach Anspruch 1, webei die Verbindungsdruckplatte (24) aus einem federnden Elastomer herge stellt ist mit einer Härte zwischen 20 und 40 Durometergraden.

4. Chipverbindungsanordnung nach Anspruch 2, wobei die Verbindungsdruckplatte (24) aus einem federnden Elastomer hergestellt ist mit einer Härte zwischen 20 und 40 Durometergraden.

5. Chipverbindungsanordnung nach einem der Ansprüche 1 bis 4 mit Abdichtmitteln (66), um den elektronischen Schaltungschip (30) in der Chipverbindungsanordnung (20) hermetisch abzudichten.

6. Chipverbindungsanordnung nach Anspruch 5, wobei das Abdichtmittel eine Abdichtrippe (66) aufweist, die von der Oberfläche der Verbindungsdruckplatte (24) hervorragt, um die Verbindungsdruckplatte (24) zwischen einer inneren Oberfläche der Abdeckung (22) und der gedruckten Schaltplatte (34) zusammenzudrücken, wenn die Chipverbindungsanordnung (20) den elektronischen Schaltungschip (30) an die gedruckte Schaltplatte (34) ankoppelt, wobei die Verbindungsschaltplatte (24) durch die Kompression veranlaßt Wird, mit diesen Oberflächen zusammenzupassen und eine Dichtung mit diesen zu bilden.

7. Chipverbindungsanordnung nach einem der Ansprüche 1 bis 4, wobei das elektronische Schaltungsverbindungsmittel eine Vielzahl von individuellen metallischen Leitern (42) aufweist, von denen jeder einen Chipkontaktanschluß (54) hat, der um den elektronischen Schaltungschip (30) herum angeordnet ist für die Kontaktierung des elektronischen Schaltungschips (30), und auch einen Linienzugkontaktierungsanschluß (54) hat, der um einen Linienzug (32) der gedruckten Schaltplatte herum angeordnet ist für das Kontaktieren dieses Linienzuges (32), wenn die Chipverbindungsanordnung (20) den elektronischen Schaltungschip (30) an die gedruckte Schaltplatte (34) ankoppelt.

8. Chipverbindungsanordnung nach Anspruch 7, wobei die metallischen Leiter (42) des elektronischen Schaltungsverbindungsmittels (26) an ein Blatt aus isolierendem Filmmaterial (52) gebunden sind und wobei die angrenzenden Kanten unmittelbar benachbarter metallischer Leiter (42) um ihre Chipkontaktierungsanschlüsse (54) herum nach außen zueinander herausragen, um benachbart zu werden, wodurch die Chipkontaktieranschlüsse (54) der metallischen Leiter (42) in einer Abstandslage so gehalten werden, daß sie richtig mit den Kontaktgliedern (104) des elektronischen Schaltungschips (30) zusammenpassen.

9. Chipverbindungsanordnung nach Anspruch 7, wobei die metallischen Leiter (42) wahlweise mit einem mechanisch festen, elektrisch isolierenden Material beschichtet sind zur Verhinderung der Bildung unbeabsichtigter elektrischer Kontakte zwischen den metallischen Leitern (42) und dem elektronischen Schaltungschip (30), wenn die Chipverbindungsanordnung (20) den elektronischen Schaltungschip (30) mit der gedruckten Schaltplatte (34) verbindet.

10. Chipverbindungsanordnung nach Anspruch 7, wobei die metallischen Leiter (42) des elektronischen Schaltungsverbindungsmittels unmittelbar zur Oberfläche der gedruckten Schaltplatte (34) benachbart sind, welche durch die Linienzugkontaktieranschlüsse (54) der metallischen Leiter (42) kontaktiert ist, wenn die Chipverbindungsanordnung (20) den elektronischen Schaltungschip (30) an die gedruckte Schaltplatte (34) ankoppelt.

11. Chipverbindungsanordnung nach Anspruch 7, wobei die Verbindungsdruckplatte (24) mit einer hervorragenden Oberfläche (64) gebildet ist, die um die Linienzugkontaktanschlüsse (54) der metallischen Leiter (42) herum angeordnet ist, um diese Linienzugkontaktieranschlüsse (54) in innigen Kontakt mit den Linienzügen (42) der gedruckten Schaltplatte (34) dann zu drücken, wenn die Chipverbindungsanordnung (20) den elektronischen Schaltungschip (30) an die gedruckte Schaltplatte (34) ankoppelt.

12. Chipverbindungsanordnung nach Anspruch 7, wobei die Verbindungsdruckplatte (24) mit einer herausstehenden Oberfläche (68) gebildet ist, Welche um die Chipkontaktieranschlüsse (54) der metallischen Leiter (42) herum angeordnet ist, um diese Chipkontaktieranschlüsse (54) in innigen Kontakt mit dem elektronischen Schaltungschip dann zu drücken, wenn die Chipverbindungsanordnung (20) den elektronischen Schaltungschip (30) mit der gedruckten Schaltplatte (34) verbindet.

13. Verfahren zum Ankoppeln eines elektronischen Schaltungschips (30) an eine gedruckte Schaltplatte (34), gekennzeichnet durch die Tätigkeiten:
Anbringen des elektronischen Schaltungschips (30) auf einer Fläche einer Verbindungsdruckplatte (24), die aus elastischem Material hergestellt ist;
Hinlegen des elektronischen Schaltungsverbindungsmittels (26) um den elektronischen Schaltungschip (30) herum, der auf der einen Fläche der Verbindungsdruckplatte (24) aufgenommen ist;
Anordnen des elektronischen Schaltungsverbindungsmittels (26), der Verbindungsdruckplatte (24) und des elektronischen Schaltungschips (30) innerhalb einer Abdeckung (22), wobei die eine Fläche der Verbindungsdruckplatte (24) von der Abdeckung (22) fortgerichtet ist; und Befestigen der Abdeckung (22) an der gedruckten Schaltplatte (34), um die Verbindungsdruckplatte (24) zu veranlassen, einen Druck auszuüben, welcher das elektronische Schaltungsverbindungsmittel (26) in innigen Kontakt mit sowohl dem elektronischen Schaltungschip (30) als auch der gedruckten Schaltplatte (34) drückt, um dadurch elektrisch den elektronischen Schaltungschip (30) mit der gedruckten Schaltplatte (34) zu verbinden.

14. Verfahren nach Anspruch 13, mit der Tätigkeit des Anbringens eines Substratverbindungsmittels (110) an der einen Fläche der Verbindungsdruckplatte (24) vor dem Anbringen des elektronischen Schaltungschips (30) auf dieser.

15. Verfahren nach Anspruch 13 Oder Anspruch 14, wobei die Verbindungsdruckplatte (24) aus einem federnden Elastomer hergestellt ist mit einer Härte zwischen 20 und 40 Durometergraden.

16. Verfahren nach Anspruch 13 oder Anspruch 14 mit der Tätigkeit des hermetischen Abdichtens des elektronischen Schaltungschips in einer Anordnung mit der Verbindungsdruckplatte (24), dem elektronischen Schaltungsverbindungsmittel (26), der Abdeckung (22) und der gedruckten Schaltplatte (34), wenn die Abdeckung (22) an der gedruckten Schaltplatte (34) angebracht wird.

17. Verfahren nach Anspruch 13 oder 14, mit der Tätigkeit des Bildens elektrischer Leitungen (42) in dem elektronischen Schaltungsverbindungsmittel (26) in einer Bahn aus metallischem Material, Wobei jeder dieser metallischen Leiter (42) mit einem Chipkontaktieranschluß (54) gebildet ist, der um den elektronischen Schaltungschip (30) herum zu legen ist, um den elektronischen Schaltungschip (30) zu kontaktieren, und auch mit einem Linienzugkontaktieranschluß (54) gebildet ist, der um einen Linienzug (32) der gedruckten Schaltplatte (34) herum zu legen ist, um den Kontakt mit diesem Linienzug (32) zu schaffen, wenn die Abdeckung (22) an der gedruckten Schaltplatte (34) angebracht wird.

18. Verfahren nach Anspruch 17, Wobei die metallischen Leiter (42) des elektronischen Schaltungsverbindungsmittels (26) an ein Blatt aus isolierendem Filmmaterial (52) gebunden sind und wobei die angrenzenden Kanten unmittelbar benachbarter metallischer Leiter (42) um die Chipkontaktieranschlüsse (54) derselben herum so gebildet sind, daß sie nach außen zueinander hervorstehen, um in die Nachbarschaft zueinander zu kommen, wodurch die Chipkontaktieranschlüsse (54) der metallischen Leiter in einem Abstand gehalten werden, um gut mit Kontaktgliedern (104) des elektronischen Schaltungschips (30) zu passen.

19. Verfahren nach Anspruch 17 mit der Tätigkeit des wahlweisen Bildens einer mechanisch festen, elektrisch isolierenden Bedeckung auf den metallischen Leitern (42), um die Bildung unbeabsichtigter, elektrischer Kontakte zwischen den metallischen Leitern (42) und dem elektronischen Schaltungschip (30) nach Anbringung der Abdeckung (22) an der gedruckten Schaltplatte (34) zu verhindern.

**Revendications**

1. Assemblage (20) de connexion de puce électronique en vue de relier une puce électronique (30) à un panneau de circuit imprimé (34), caractérisé par:

une plaque de pression de connexion (24) réalisée en un matériau élastique pour recevoir la puce électronique (30) sur une de ses faces;

des moyens (26) de connexion de circuit électronique en vue de relier électriquement la puce électronique (30) reçue sur ladite face de la plaque de pression de connexion (24) au panneau de circuit imprimé (34); et un couvercle (22) destiné à être fixé au panneau de circuit imprimé (34) et pour entourer la plaque de pression de connexion (24), les moyens (26) de connexion du circuit électronique et de la puce électronique (30) à ladite face de la plaque de pression de connexion (24) écartée du couvercle (22); l'assemblage (20) étant agencé de sorte que lorsque le couvercle (22) est fixé au panneau de circuit imprimé (34), la plaque de pression de connexion (24) exerce une pression poussant les moyens (26) de connexion du circuit électronique en contact intime avec à la fois la puce électronique (30) et le panneau de circuit imprimé (34) en vue de relier ainsi électriquement la puce électronique (30) au panneau de circuit imprimé (34).

2. Assemblage de connexion de puce électronique selon la revendication 1, comprenant des moyens de connexion (110) de substrat sur ladite face de la plaque de pression de connexion (24) en vue de relier un substrat de la puce électronique (30) aupanneau de circuit imprimé (34) lorsque l'assemblage (20) relie la puce électronique (30) au panneau de circuit imprimé (34).

3. Assemblage de connexion de puce électronique selon la revendication 1, dans lequel la plaque de pression de connexion (24) est réalisée en élastomère élastique possédant une dureté comprise entre 20 et 40 duromètres.

4. Assemblage de puce électronique selon la revendication 2, dans lequel la plaque de pression de connexion (24) est réalisée en un élastomère élastique possédant une dureté comprise entre 20 et 40 duromètres.

5. Assemblage de connexion de puce électronique selon l'une quelconque des revendications 1 à 4, comprenant des moyens d'étanchéité (66) en vue de sceller hermétquement la puce électronique (30) à l'intérieurde l'assemblage (20) de connexion de la puce.

6. Assemblage de connexion de puce électronique selon la revendication 5, dans lequel les moyens d'étanchéité comprennent une nervure d'étanchéité (66) faisant saillie depuis une surface de la plaque de pression de connexion (24) en vue de comprimer la plaque de pression de connexion (24) entre une surface interne du couvercle (22) et le panneau de circuit imprimé (34) lorsque l'assemblage (20) de connexion de puce électronique relie la puce électronique (30) au panneau de circuit imprimé (34), compression qui amène la plaque de pression de connexion (24) à s'adapter à et à former un joint hermétique avec ces surfaces.

7. Assemblage de connexion de puce électronique selon l'une quelconque des revendications 1 à 4, dans lequel les moyens de connexion du circuit électronique comprennent un ensemble de conducteurs métalliques individuels (42) possédant chacun une borne (54) venant au contact de la puce disposés autour de la puce électronique (30) en vue de venir au contact de la puce électronique (30), et possédant également une borne (54) de contact d'une piste disposée autour d'une piste (32) du panneau de circuit imprimé en venir en contact avec cette piste (32) lorsque l'assemblage (20) de connexion de la puce relie la puce électronique (30) au panneau de circuit imprimé (34).

8. Assemblage de connexion de puce électronique selon la revendication 7, dans lequel les conducteurs métalliques (42) des moyens (26) de connexion du circuit électronique sont liés à une feuille de matériau pelliculaire isolant (52), et dans lequel les bords contigus de conducteurs métalliques (42) immédiatement adjacents autour des bornes (54) venant au contact de la puce de ceux-ci font saillie vers l'extérieur l'un vers l'autre pour être juxtaposés, de telle sorte que les bornes (54) venant au contact de la puce des conducteurs métalli ques (42) sont maintenues espacées de façon à s'adapter correctement aux pattes de contact (104) de la puce électronique (30).

9. Assemblage de connexion de puce électronique selon la revendication 7, dans lequel les conducteurs métalliques (42) sont sélectivement revêtus d'un matériau électriquement isolant, mécaniquement résistant en vue d'empêcher la formation de contacts électriques inintentionnels entre les conducteurs métalliques (42) et la puce électronique (30) lorsque l'assemblage (20) de puce électronique relie la puce électronique (30) au panneau de circuit imprimé (34).

10. Assemblage de connexion de puce électronique selon la revendication 7, dans lequel les conducteurs métalliques (42) des moyens deconnexion du circuit électronique sont immédiatement adjacents à la surface du panneau de circuit imprimé (34) en contact avec les bornes (54) venant au contact des pistes des conducteurs métalliques (42) lorsque l'assemblage (20) de connexion de puce relie la puce électronique (30) au panneau de circuit imprimé (34).

11. Assemblage de connexion de puce électronique selon la revendication 7, dans lequel la plaque de pression de connexion (24) est réalisée avec une surface saillante (64) disposée autour des bornes (54) venant au contact des pistes des conducteurs métalliques (42) en vue de pousser ces bornes (54) venant au contact des pistes en contact intime avec les pistes (32) du panneau de circuit imprimé (34) lorsque l'assemblage (20) de connexion de la puce relie la puce électronique (30) au panneau de circuit imprimé (34).

12. Assemblage de connexion de puce électronique selon la revendication 7, dans lequel la plaque de pression de connexion (24) est réalisée avec une surface saillante (68) disposée autour des bornes (54) venant au contact de la puce des conducteurs métalliques (42) en vue de pousser ces bornes (54) venant au contact de la puce en contact intime avec la puce électronique (30) lorsque l'assemblage (20) de connexion de puce relie la puce électronique (30) au panneau de circuit imprimé (34).

13. Procédé de connexion d'une puce électronique (30) à un panneau de circuit imprimé (34), caractérisé par les opérations consistant à:

monter la puce électronique (30) sur une face d'une plaque de pression de connexion (24) réalisée en matériau élastique;

disposer des moyens de connexion (26) du circuit électronique autour de la puce électronique (30) reçue sur ladite face de la plaque de pression de connexion (24);

disposer les moyens de connexion (26) du circuit électronique, la plaque de pression de connexion (34), et la puce électronique (30) à l'intérieur d'un couvercle (22) avec ladite face de la plaque de pression de connexion (24) écartée du couvercle (22); et

fixer le couvercle (22) au panneau de circuit imprimé (34) pour amener la plaque de pression de connexion (24) à exercer une pression poussant les moyens de connexion (26) du circuit électronique en contact intime avec à la fois la puce électronique (30) et le panneau de circuit imprimé (34) pour ainsi relier électriquement la puce électronique (30) au panneau de circuit imprimé (34).

14. Procédé selon la revendication 13, comprenant l'opération de montage d'un moyen de connexion (110) de substrat à ladite face de la plaque de pression de connexion (24) préalablement au montage de la puce électronique (30) sur celle-ci.

15. Procédé selon la revendication 13 ou la revendication 14, dans lequel la plaque de pression de connexion (24) est réalisée en un élastomère élastique possédant une dureté comprise entre 20 et 40 duromètres.

16. Procédé selon la revendication 13 ou la revendication 14 comportant l'opération de scellement hermétique de la puce électronique à l'intérieur d'un assemblage comportant la plaque de pression de connexion (24), les moyens de connexion (26) du circuit électronique, le couvercle (22), et le panneau de circuit imprimé (34) lorsque le couvercle (22) est fixé au panneau de circuit imprimé (34).

17. Procédé selon la revendication 13 ou la revendication 14, comportant l'opération de façonnage de conducteurs électriques (42) compris dans les moyens de connexion (26) du circuit électronique dans une bande de matériau métallique, chacun de ces conducteurs métalliques (42) étant réalisé avec une borne (54) venant au contact de la puce pour être disposée autour de la puce électronique (30) de façon à venir au contact de la puce électronique (30), et étant également façonné avec une borne (54) venant au contact d'une piste destinée à être disposée autour d'une piste (32) du panneau de circuit imprimé (34) de façon à venir au contact de cette piste (32) lorsque le couvercle (22) est fixé au panneau de circuit imprimé (34).

18. Procédé selon la revendication 17, dans lequel les conducteurs métalliques (42) des moyens de connexion (26) du circuit électronique sont liés à une feuille de matériau pelliculaire isolant (52), et dans lequel les bords contigus de conducteurs métalliques (42) immédiatement adjacents autour des bornes (54) venant au contact de la puce de ceux-ci sont façonnés pour faire saillie vers l'extérieur l'un vers l'autre pour être juxtaposés, de telle sorte que les bornes (54) venant au contact de la puce des conducteurs métalliques sont maintenus espacés de façon à s'adapter correctement à des pattes de contact (104) de la puce électronique (30).

19. Procédé selon la revendication 17, comportant l'opération de façonnage sélectif d'un revêtement électriquement isolant, mécaniquement résistant sur les conducteurs métalliques (42) en vue d'empêcher la formation de contacts électriques inintentionnels entre les conducteurs métalliques (42) et la puce électronique (30) lors de la fixation du couvercle (22) au panneau de circuit imprimé (34).

0 148 820

FIG. 1

FIG. 2

1

FIG. 7A

FIG. 3B

FIG. 7B

FIG. 3C

FIG 7C

FIG 3D

FIG. 4

FIG. 5

FIG. 6